Europäisches Patentamt

European Patent Office

Office européen des brevets

(19)

(11) EP 0 662 984 B1

(12) EUROPÄISCHE PATENTSCHRIFT

(45) Veröffentlichungstag und Bekanntmachung des Hinweises auf die Patenterteilung:
14.10.1998 Patentblatt 1998/42

(21) Anmeldenummer: 94922221.0

(22) Anmeldetag: 22.07.1994

(51) Int Cl.[6]: C08J 7/02, C08J 7/12, C23C 18/20, C23C 18/22

(86) Internationale Anmeldenummer:
PCT/DE94/00877

(87) Internationale Veröffentlichungsnummer:
WO 95/04103 (09.02.1995 Gazette 1995/07)

(54) **VERFAHREN ZUM BEHANDELN VON KUNSTSTOFFOBERFLÄCHEN UND ANQUELL-LÖSUNG**

PROCESS FOR TREATING PLASTIC SURFACES AND SWELLING SOLUTION

PROCEDE DE TRAITEMENT DE SURFACES EN PLASTIQUE ET SOLUTION DE GONFLEMENT

(84) Benannte Vertragsstaaten:
AT DE ES FR GB IT NL SE

(30) Priorität: 30.07.1993 DE 4326079

(43) Veröffentlichungstag der Anmeldung:
19.07.1995 Patentblatt 1995/29

(73) Patentinhaber: ATOTECH DEUTSCHLAND GMBH
10553 Berlin (DE)

(72) Erfinder:
• SCHÄFER, Claus
D-10999 Berlin (DE)
• MIDDEKE, Hermann-Josef
D-12203 Berlin (DE)

(74) Vertreter: Effert, Bressel und Kollegen
Radickestrasse 48
D-12489 Berlin (DE)

(56) Entgegenhaltungen:
EP-A- 0 204 943          EP-A- 0 316 061
WO-A-90/05203

• Roempp Chemie Lexikon, 9. Auflage, Seite 3,642

Bemerkungen:
Die Akte enthält technische Angaben, die nach dem Eingang der Anmeldung eingereicht wurden und die nicht in dieser Patentschrift enthalten sind.

**Beschreibung**

Die Erfindung betrifft ein Verfahren zum Behandeln von Polymere enthaltenden Werkstückoberflächen sowie eine wäßrige alterungsbeständige Lösung.

Kunststoffe können nach verschiedenen Verfahren mit Metallen naßchemisch beschichtet werden: üblich ist eine Hydrophilisierung und Anrauhung der Polymeroberflächen und anschließende Erzeugung der Leitfähigkeit, damit galvanisch Metall abgeschieden werden kann. Bis vor einigen Jahren war es üblich, dazu die vorbereitete Oberfläche mit einem katalytisch wirksamen Metall zu bekeimen und anschließend chemisch reduktiv aus einem geeigneten Bad ein Metall, meist Kupfer, abzuscheiden. Inzwischen sind Verfahren im Einsatz, die eine galvanische Metallisierung direkt ohne außenstromlose Bäder erlauben. Anstelle des katalytisch wirksamen Aktivators wird eine elektrisch leitfähige Schicht erzeugt. Diese Schicht kann aus einem Metall bestehen, beispielsweise Palladium, besteht aber im allgemeinen aus einem Metallchalocogenid, einer Kohlenstoff-Schicht, die aus einer Kohlenstoff-Suspension hergestellt wird, oder aus einem elektrisch leitfähigen Polymeren, beispielsweise Polypyrrol.

Als Kunststoffe werden die folgenden Polymere eingesetzt: Epoxidharz, Polycarbonat, Polyphenylenoxid, Polyester, Polyamid, Polyimid, Polyetherimid, Polystyrol, Polyvinylchlorid oder Acrylnitril-Butadien-Styrol-Copolymere (ABS).

Für die Herstellung von Leiterplatten für die Elektronik ist es bei doppelseitigen Leiterplatten oder Mehrlagenschaltungen nötig, die Wandungen der eingebrachten Bohrungen mit Metall zu belegen, um zwischen den metallischen Lagen Kontakt herzustellen und um bedrahtete Bauelemente durch Löten befestigen zu können. Die aufgebrachte Metallschicht soll hierzu auf dem Leiterplatten-Dielektrikum und schon vorhandenem Metall, beispielsweise der Metallkaschierung und den Innenlagen von Mehrlagenschaltungen, fest haften und insbesondere dem Lötprozeß widerstehen.

Auch bei der dekorativen Metallisierung von Kunststoffteilen wird ein haftfester Verbund zwischen Kunststoffsubstrat und metallischer Deckschicht benötigt. Das gleiche gilt bei der funktionellen Metallisierung von Teilen, beispielsweise zur Abschirmung gegen elektromagnetische Strahlung.

Der haftfeste Verbund des jeweils abgeschiedenen Metalls zum polymeren Substrat und damit die funktionelle Qualität des herzustellenden Werkstückes wird hauptsächlich durch die Art des Vorbehandlungsverfahrens und die dabei verwendeten Materialien bestimmt. Meist besteht der erste Verfahrensschritt darin, die Polymermatrix anzuquellen. Der zweite Verfahrensschritt besteht aus einem oxidativen, die Polymermatrix abbauenden und damit anrauhenden Ätzschritt. Ätzmedien sind zum Beispiel alkalische Permanganatlösung oder Chromsäure. Jedoch sind auch Verfahren bekannt, bei denen das Substrat zur Vorbehandlung lediglich angequollen und nicht in einer oxidativen Ätzlösung behandelt wird.

Insbesondere bei der Vorbehandlung von Bohrungen in Leiterplattenmaterial wird eine Mikroanrauhung des polymeren Substrats gefordert, damit abgeschiedenes Metall gut haften kann. Bei der Reinigung der Bohrungen von beim Bohren verschmiertem Polymeren kann ein Ätzmedium wie zum Beispiel eine alkalische Permanganatlösung zwar Bohrmehl und verschmiertes Polymermaterial abätzen, eine Mikroanrauhung wird aber nur dann erreicht, wenn das Leiterplattenpolymere vor dem Ätzschritt mit einer geeigneten Quell-Lösung aufgequollen worden ist.

Quell-Lösungen bestehen im allgemeinen aus Wasser, einem organischen Quellmittel und meist einer in Wasser alkalisch reagierenden Substanz. Die eingesetzten organischen Quellmittel weisen in der Regel hohe Siedepunkte auf und haben nur eine begrenzte Mischbarkeit mit Wasser. Zum Anquellen von Polymeren werden meist wäßrige Lösungen von Ethylenglykolderivaten eingesetzt.

In der US-PS 3,898,136 wird die Oberflächenbehandlung von Artikeln aus Epoxid- und Polyphenylenoxidharz mit Lösungsmitteln der allgemeinen Formel $RO(AO)_nR'$, wobei R oder R' eine Alkyl- oder Acylgruppe mit nicht mehr als vier Kohlenstoffatomen und die andere Gruppe ein Wasserstoffatom, eine Alkyl- oder Acylgruppe mit nicht mehr als vier Kohlenstoffatomen, A eine verzweigte oder nichtverzweigte $C_2$- bis $C_4$-Alkylengruppe darstellen und n eine ganze Zahl von 1 bis 4 ist, und das nachfolgende Ätzen beschrieben, um eine haftfeste Verbindung des Substrats mit der nachfolgend aufgebrachten Metallschicht zu erzielen.

In der DE-A 37 40 369 wird das Quellmittel mit einer anorganischen oder organischen Base kombiniert, die durch Hydrolyse polarer chemischer Bindungen des Polymeren die Quellwirkung unterstützt.

In der US-PS 4,775,557 ist die Vorbehandlung von Polycarbonaten mit Verbindungen der allgemeinen Formel $R_1(OC_nH_{2n})_m$-$R_2$, wobei $R_1$ und $R_2$ unabhängig voneinander Arylgruppen oder Alkylgruppen mit 1 - 4 Kohlenstoffatomen darstellen und n = 2 - 4 und m = 1 - 5 sind, und nachfolgende Ätzbehandlung beschrieben, um eine gute Bedeckung der Polymeroberfläche mit darauffolgend abzuscheidendem Metall und eine hohe Haftfestigkeit zu erzielen.

In der WO 89/10431 wird eine Quell-Lösung beschrieben, die ein mit Wasser nicht mischbares organisches Lösemittel enthält, wobei durch Zusatz einer oberflächenaktiven Substanz eine homogene und klare Lösung erhalten wird. Der Nachteil der Verwendung von oberflächenaktiven Substanzen besteht darin, daß die diese Verbindungen enthaltenden Quell-Lösungen im allgemeinen stark schäumen, so daß deren Einsatzfähigkeit beschränkt ist.

In der US-PS 5,049,230 wird ein Vorbehandlungsverfahren für Polymere zum nachfolgenden Ätzen beschrieben, wobei Gemische von das Polymer anlösenden und das Polymer nicht angreifenden organischen Verbindungen in alkalischem Medium eingesetzt werden. Zur Lösungsvermittlung der Komponenten werden organische Verbindungen, wie beispielsweise niedere Alkohole wie Methanol, Ethanol, iso-Propanol, Alkanolamine und Phenolamine, tertiäre Amine, Carbonsäuren und andere, verwendet.

In der WO 85/05755 wird eine Quell-Lösung beschrieben, die Verbindungen der allgemeinen Formel $R_1O\text{-}C\text{-}(CH_2)_m\text{-}C\text{-}OR_2$ und $R_3\text{-}(OCH_2CH_2)_nO\text{-}R_4$ enthält, wobei $R_1$, $R_2$, $R_3$ und $R_4$ unabhängig voneinander entweder Wasserstoffatome, Aryl- oder Alkylgruppen mit 1 - 4 Kohlenstoffatomen darstellen und m = 0 - 2 sowie n = 2 - 5 sind. Bevorzugte Verbindungen sind Propylenglykolmonomethylether und Propylenglykolmonopropylether beziehungsweise Tetraethylenglykol in alkalischer Lösung.

Die genannten Verfahren und Vorbehandlungslösungen weisen den Nachteil auf, daß bei höheren Temperaturen und insbesondere gleichzeitig höherem Gehalt an Alkalisierungsmitteln, wie beispielsweise Alkalihydroxiden, eine Entmischung der Quell-Lösung eintritt, da die Alkalisierungsmittel durch Reaktion mit dem in der Luft enthaltenen Kohlendioxid in Carbonate übergehen, die in der Quell-Lösung schwerlöslich sind. Die hierbei stattfindende chemische Reaktion wird durch folgende Reaktionsgleichung beschrieben:

$$CO_2 + 2\,NaOH \rightarrow Na_2CO_3 + H_2O$$

Die eine der bei der Entmischung der Lösung entstehenden flüssigen Phasen enthält überwiegend das Quellmittel, während die andere überwiegend aus Wasser besteht. Je höher die Betriebstemperatur und je höher die Konzentration von Alkalihydroxid in der Quell-Lösung sind, desto schneller bildet sich Carbonat, das die Entmischung des Quellers fördert. Die Lösung muß daher nach einer bestimmten Betriebsdauer entweder mit Wasser verdünnt und mit neuem Lösungsmittel ergänzt werden, beziehungsweise gänzlich verworfen werden.

Eine andere bekannte Möglichkeit zur Verringerung dieser Probleme besteht darin, die Quell-Lösung von ihrer Salzfracht zu befreien oder bei einer niedrigeren Temperatur zu betreiben, so daß die Entmischung erst nach längerer Betriebsdauer auftritt. Jedoch sind diese Maßnahmen aufwendig, kostspielig und umweltschädlich, da wertvolle Rohstoffe verbraucht werden, die Behandlungsanlagen während der für die Instandhaltung erforderlichen Wartungszeiten für eine Behandlung des Gutes nicht zur Verfügung stehen und große Mengen verworfener Rohstoffe entstehen, die nur schwer entsorgt werden können.

Die genannten Nachteile wurden in der Vergangenheit in Kauf genommen, jedoch ist ein Betrieb mit den vorbekannten Quell-Lösungen aus den genannten Gründen nicht wirtschaftlich, da diese nicht alterungsbeständig sind.

Der vorliegenden Erfindung liegt von daher das Problem zugrunde, die Nachteile des Standes der Technik zu vermeiden, geeignete Verbindungen zu finden und das Vorbehandlungsverfahren auch für schwierige Anwendungsfälle zu optimieren.

Gelöst wird dieses Problem durch die Ansprüche 1 und 7. Bevorzugte Ausführungsformen der Erfindung sind in den Unteransprüchen beschrieben.

Das erfindungsgemäße Verfahren benutzt wäßrige alterungsbeständige Lösungen zum Anquellen von Polymere enthaltenden Werkstückoberflächen, die zum Anquellen geeignete organische Quellmittel, Alkalisierungsmittel, basische Salze, insbesondere Alkalicarbonate, und zusätzlich mindestens einen Lösungsvermittler für die Quellmittel in der Lösung enthalten.

Als erfindungsgemäße Lösungsvermittler werden organische Verbindungen der allgemeinen Formel

$$HO\text{-}A(OH)\text{-}R$$

eingesetzt, wobei A eine verzweigte oder unverzweigte Alkylenkette, R eine verzweigte oder unverzweigte Alkylgruppe oder Wasserstoff ist und A und R zusammen mindestens drei Kohlenstoffatome enthalten.

Bevorzugt werden Verbindungen eingesetzt, bei denen A zwei bis sechs Kohlenstoffatome enthält, beziehungsweise R eine Alkylgruppe mit weniger als vier Kohlenstoffatomen oder Wasserstoff ist.

Überraschend wurde festgestellt, daß bestimmte Alkohole die Entmischung der wäßrigen Quell-Lösungen wirksam verhindern. In der nachfolgenden Tabelle sind einige dieser Verbindungen zusammen mit der gemessenen Entmischungstemperatur aufgeführt. Die Quell-Lösung bestand aus 210 g/l Diethylenglykolmonobutylether, 20 g/l Natriumhydroxid, 10 g/l Natriumcarbonat und einem Lösungsvermittler in Wasser. Die getesteten Lösungsvermittler waren in den Quell-Lösungen in einer Konzentration von jeweils 80 g/l enthalten.

Tabelle

| Entmischungstemperaturen | |
| --- | --- |
| Lösungsvermittler | Entmischungstemperatur [°C] |
| Ohne Lösungsvermittler | 42 °C |
| Propan-1,2,3-triol | 40 °C |
| Hexan-1-ol | < 52 °C |
| Ethylenglykol | 52 °C |
| 1-Aminoethan-2-ol | 54 °C |
| Hexan-1,6-diol | 55 °C |
| Triethylenglykol | 58 °C |
| | |
| 2,2-Dimethyl-1,3-propandiol | 62 °C |
| Propan-1,2-diol | 68 °C |
| Pentan-1,5-diol | 68 °C |
| Butan-1,4-diol | 70 °C |
| Butan-1,3-diol | 73 °C |
| Butan-1,2-diol | 78 °C |

Die Ergebnisse zeigen, daß insbesondere die Diole des Propans, Butans und Pentans als Lösungsvermittler wirksam sind, während Verbindungen wie beispielsweise Ethylenglykol, Propan-1,2,3-triol, Hexan-1-ol, 1-Aminoethan-2-ol und Triethylenglykol nicht ausreichend wirksam sind. In der beschriebenen Lösung konnte bei Verwendung der erfindungsgemäßen Verbindungen die Betriebstemperatur von 42 °C auf maximal 78 °C erhöht werden, ohne daß eine Entmischung der Lösung auftritt. Mit 1,2-Butandiol zeigte eine Quell-Lösung auch mit 30 g/l Natriumhydroxid sogar bei 70 °C noch keine Entmischung. Die Entmischungstemperatur hängt jedoch auch von den Konzentrationen der anderen Inhaltsstoffe der Quell-Lösung ab. Quell-Lösungen mit höheren Alkaligehalten und höheren Betriebstemperaturen ermöglichen daher die Vorbehandlung von Polymeren in wesentlich kürzerer Zeit als dies bisher möglich war, ohne daß eine Entmischung der Quell-Lösung eintritt.

Es wurde gefunden, daß Arbeitstemperaturen der Quell-Lösung oberhalb 60 °C und insbesondere zwischen 60 °C und 90 °C besonders wirksam sind. Daher sollte die Entmischungstemperatur der Quell-Lösung ebenfalls oberhalb dieses Wertes liegen. Als Lösungsvermittler sind erfindungsgemäß die Verbindungen 2,2-Dimethyl-1,3-propandiol, Propan-1,2-diol, Pentan-1,5-diol, Butan-1,4-diol, Butan-1,3-diol und Butan-1,2-diol besonders gut geeignet, da sie die Entmischungstemperatur auf Werte oberhalb 60 °C erhöhen.

Die Konzentration des Lösungsvermittlers in der Quell-Lösung wird je nach den Erfordernissen zwischen 10 g/l und 500 g/l, bevorzugt zwischen 50 g/l und 200 g/l, eingestellt. Maßgeblich hierfür sind die gewünschte obere Betriebstemperatur der Quell-Lösung und die Konzentrationen von Alkalihydroxid und dem sich durch Luftkontakt daraus bildenden Alkalicarbonat in der Quell-Lösung. Je höher die Betriebstemperatur und je höher die Konzentrationen von Alkalihydroxid und des Carbonats in der Quell-Lösung sind, desto höher müssen die Konzentrationen des Lösungsvermittlers in der Quell-Lösung sein. Andererseits ist dann ein extrem hoher Gehalt an Lösungsvermittler zu vermeiden, wenn eine unwirtschaftliche Verschleppung bei der Behandlung der Polymeren befürchtet werden muß, um die Kosten für Rohstoffe und die Abwasserbehandlung möglichst gering zu halten. Ein bevorzugter Konzentrationsbereich liegt daher zwischen 50 g/l und 200 g/l.

Als Quellmittel können Verbindungen der allgemeinen Formel $R_1O$-$(A'O)_p$-$R_2$ eingesetzt werden, wobei $R_1$ und $R_2$ unabhängig voneinander gewählt werden und Alkyl- oder Acylgruppen mit nicht mehr als fünf Kohlenstoffatomen, Arylgruppen oder Wasserstoff sind, wobei höchstens eine der beiden Gruppen Wasserstoff ist, A' eine Kohlenstoffgruppe mit zwei bis fünf Kohlenstoffatomen ist und p = 1, 2, 3 oder 4 ist. $R_1$ und $R_2$ können gleiche oder unterschiedliche Gruppen sein.

Die Wahl des Quellmittels richtet sich nach der Art des zu behandelnden Substratmaterials. Für die Anwendung in der Leiterplattentechnik, bei der als Substrat Epoxidharz vorbehandelt wird, wird beispielsweise Diethylenglykolmonobutylether verwendet. Für die Vorbehandlung von thermoplastischen Kunststoffen, wie beispielsweise Polycarbonaten oder deren Mischungen mit ABS, sind bevorzugt Etherester wie zum Beispiel Diethylenglykolmonoethyletheracetat geeignet.

Als Alkalisierungsmittel können unterschiedliche Verbindungen eingesetzt werden. Hierzu zählen neben den wegen der geringen Kosten bevorzugten Alkalihydroxiden auch quaternäre Ammoniumbasen. Aus diesen Verbindungen entstehen durch Kontakt der Quell-Lösung mit der Luft und Reaktion mit dem darin enthaltenen Kohlendioxid die entsprechenden Carbonate als basische Salze. Die Reaktionsgeschwindigkeit zwischen dem Alkalisierungsmittel und Kohlendioxid und damit die Bildungsgeschwindigkeit des Carbonats hängt von der Temperatur der Quell-Lösung, von der Kontaktoberfläche zwischen Quell-Lösung und Luft und damit von der Art, wie die Lösung bewegt wird (Stehen der Lösung im Tauchbehälter, Sprühen oder Schwallen der Lösung, eventuelle Lufteinblasung in die Quell-Lösung) sowie von der Konzentration des Alkalisierungsmittels ab.

Da die Behandlungszeit von der Betriebstemperatur der Quell-Lösung abhängt, wird diese in Abhängigkeit von den Verfahrensbedingungen eingestellt. Außerdem richtet sich die Betriebstemperatur nach der Art des zu behandelnden Polymeren, dem eingesetzten Quellmittel, der Konzentration des Alkalisierungsmittels und anderen Faktoren. Vorzugsweise wird eine Temperatur oberhalb 60 °C eingestellt. Die obere Temperaturgrenze hängt von dem Siedepunkt des Quellmittels in der Quell-Lösung ab und die untere von der gewünschten Behandlungszeit. Je höher die Temperatur ist, desto kürzer kann die Behandlungszeit gewählt werden. Außerdem ist zu beachten, daß die Verdampfungsverluste des Quellmittels und der Energieverbrauch bei hohen Temperaturen deutlich höher sind als bei niedrigeren. Daher wird ein Temperaturbereich zwischen etwa 60 °C und 90 °C bevorzugt gewählt, um einen Kompromiß zwischen zu geringer Behandlungsdauer, zu hohem Verdampfungsverlust des Quellmittels und dem Eintritt der Entmischung der Quell-Lösung zu finden.

Die erfindungsgemäße Quell-Lösung kann auf verschiedene Weise mit dem Behandlungsgut in Kontakt gebracht werden: üblicherweise wird das Polymer in die Lösung getaucht. Alternativ kann die Quell-Lösung auch durch Sprühen, Schwallen oder Spritzen auf die Polymeroberfläche aufgetragen werden.

Im Anschluß an die Quellbehandlung in der erfindungsgemäßen Lösung wird das Polymer im allgemeinen einer Anrauhbehandlung in einer Ätzlösung unterworfen. Hierzu werden vorzugsweise alkalische Permanganatlösungen oder Chromsäure enthaltende Lösungen eingesetzt. In Abhängigkeit von dem zu behandelnden Polymeren kann es jedoch auch vorteilhaft sein, das Polymer nur in der Quell-Lösung zu behandeln und nicht in einer Ätzlösung.

Für die Metallisierung werden die aus Polymeren bestehenden Werkstückoberflächen anschließend den für sich bekannten Verfahrensschritten der Konditionierung (Vorbehandlung für die nachfolgende Aktivierung mit Verbindungen, die die Bekeimung verbessern), gegebenenfalls der Ätzreinigung von vorhandenen Metallflächen wie beispielsweise der Kupferflächen auf Leiterplatten (Reinigung), der Aktivierung (Bekeimung für die stromlose Metallisierung mit edelmetallhaltigen Lösungen) und der Metallisierung unterworfen. Hierbei können sowohl konventionelle stromlose Verfahren, bei denen zunächst eine erste leitfähige Metallschicht aus außenstromlos arbeitenden Metallbädern abgeschieden wird und anschließend die galvanische Metallisierung erfolgt, oder die direkte galvanische Metallisierung ohne Verwendung außenstromloser Metallbäder eingesetzt werden. Es können beliebige Metalle, wie beispielsweise Kupfer, Nickel oder Edelmetalle abgeschieden werden.

Eine bevorzugte Anwendung der erfindungsgemäßen Lösung besteht in der Vorbehandlung von Leiterplattenbohrungen zur nachfolgenden Metallisierung. In diesem Fall wird eine ausreichende Mikroaufrauhung der Bohrlochwandung gefordert.

Die erfindungsgemäße Lösung kann jedoch auch zur Vorbehandlung von Polymeren, die zu dekorativen oder funktionellen Zwecken nachfolgend metallisiert werden, dienen. Typische Anwendungsbeispiele sind die Abschirmung von Gehäusen gegen elektromagnetische Strahlung, beispielsweise von Computermonitoren und Funkgeräten für die funktionelle Beschichtung oder die Herstellung von Modeschmuck, Sanitärarmaturen, Möbelbeschlägen, Autozubehör für dekorative Anwendungen.

Die folgenden Beispiele dienen zur Erläuterung der Erfindung:

Beispiel 1:

Eine Quell-Lösung aus 100 g/l Diethylenglykolmonobutylether, 150 g/l Butan-1,4-diol und 50 g/l Natriumhydroxid, Rest Wasser, wurde auf 80 °C erwärmt. In der völlig klaren Lösung wurde gebohrtes FR4-Leiterplattenmaterial (Epoxidharz-/Glasfasermaterial mit Flammresistenz, Lieferant beispielsweise Ciba Geigy AG) 5 min lang gequollen, anschließend 1 min lang in Wasser gespült und dann 5 min lang in einer Lösung, die aus 70 g/l Natriumpermanganat und 50 g/l Natriumhydroxid angesetzt worden war, geätzt. Oberflächlich gebildeter Braunstein wurde nach einem anschließenden Spülvorgang durch Reduktion mit einer sauren Wasserstoffperoxid-Lösung entfernt. Eine nachfolgende Überprüfung der Harzoberfläche im Bohrloch durch Rasterelektronenmikroskopie (REM) zeigte eine einwandfreie, sehr gleichmäßige Mikroaufrauhung des Polymeren.

Beispiel 2:

In einer horizontal arbeitenden Anlage zur Fertigung von Leiterplatten wurde in einem ersten Schritt eine wäßrige Quell-Lösung mit 100 g/l Diethylenglykolmonobutylether, 150 g/l Butan-1,4-diol und 50 g/l Natriumhydroxid eingesetzt.

Die Betriebstemperatur lag bei 80 °C. Aus der Durchlaufgeschwindigkeit von 0,6 m/min errechnete sich eine Verweilzeit der Leiterplatten in der Quell-Lösung von 40 Sekunden. Der zweite Behandlungsschritt bestand aus einer Permanganatlösung, die etwa 50 g/l Kaliumpermanganat, 9 g/l Kaliummanganat und 45 g/l Natriumhydroxid enthielt. Oberflächlich gebildeter Braunstein wurde mit einer wäßrigen Lösung aus Hydroxylammoniumsulfat entfernt. Testplatten wurden nach dieser Reduktion durch REM untersucht. Die Polymeroberfläche wies die gewünschte Mikroaufrauhung auf.

Beispiel 3:

Spritzgußteile für Möbelbeschläge und Computer-Monitorgehäuse aus dem Kunststoff Bayblend FR1441 (Warenzeichen der Fa. Bayer AG für Kunststoffe mit einer Mischung aus einem Polycarbonat und einem Acrylnitril-Butadien-Styrol-Copolymer) wurden 5 min lang bei 60 °C mit einer wäßrigen Quell-Lösung aus 100 g/l Diethylenglykolmonomethyletheracetat, 150 g/l Butan-1,4-diol, 20 g/l Natriumcarbonat und 50 g/l Natriumhydroxid behandelt. Nach einminütigem Spülen in Stadtwasser wurden die Teile bei 70 °C in einer Lösung aus 140 g/l Natriumpermanganat und 40 g/l Natriumhydroxid hydrophilisiert. Nach einem weiteren Spülschritt wurde gebildeter Braunstein in einer schwefelsauren Wasserstoffperoxid-Lösung entfernt, die Oberflächen wie üblich mit einem handelsüblichen ionischen palladiumhaltigen Aktivator katalysiert und anschließend reduktiv mit Kupfer belegt. Nach dem galvanischen Verstärken der gebildeten Kupferschicht auf etwa 30 µm Dicke wurde mit einer handelsüblichen Zugprüfmaschine und genormten Haftstreifen die erzielte Haftfestigkeit des Kupfers auf den Teilen ermittelt. Es wurden Werte von 0,3 N/mm gemessen.

Beispiel 4:

Die Behandlung des Polymeren erfolgte wie im Beispiel 3 angegeben. Anstelle von Bayblend wurde jedoch Polyetherimid eingesetzt. Es wurden mittlere Haftfestigkeiten von 0,6 N/mm erzielt.

Beispiele 5 bis 8:

Die Polymere wurden wie in den Beispielen 1 bis 4 angegeben behandelt. Den Quell-Lösungen wurden jedoch zusätzlich je 20 g/l Natriumcarbonat zugegeben, um eine Kohlendioxidaufnahme aus der Luft durch das Natriumhydroxid zu simulieren. Die Lösungen blieben auch bei 80 °C klar. Bei der Mikroaufrauhung der Polymere wurden keine Unterschiede zu den Ergebnissen in den Beispielen 1 - 4 gefunden.

Beispiel 9 :

Es wurden mit Bohrungen versehene Leiterplatten nach den in Beispiel 2 angegebenen Bedingungen metallisiert. Es handelte sich in diesem Fall um vierlagige Mehrlagenschaltungen. Nach der Metallisierung wurden Prüflinge der Leiterplatten vor und nach einem Lötschocktest (sechs Zyklen von je 10 Sekunden in Zinn/Blei-Lot bei 288 °C und einer Abkühlphase) per Querschliff begutachtet. Es wurden weder Abrisse oder sonstige Defekte an den metallisierten Innenlagen gefunden noch Fehler wie "pocket voids", die durch das Eindringen der Quell-Lösung in das Polymere und Verdampfen beim Lötschock entstehen. Die Bedeckung von Harz und Glasfasern mit Metall war einwandfrei.

Vergleichsbeispiel 10:

Die in Beispiel 2 angegebene Quell-Lösung wurde ohne Butan-1,4-diol und ohne Natriumcarbonat angesetzt und war klar. Die Lösung wurde bei 80 °C zum Behandeln von Leiterplatten verwendet. Nach Bildung von Natriumcarbonat durch Alterung der Quell-Lösung wurde die Lösung trübe, und das Quellmittel Diethylenglykolmonobutylether bildete neben der wäßrigen eine zweite flüssige Phase. Die Lösung war zu verwerfen.

Vergleichsbeispiel 11:

Die in Beispiel 2 angegebene Quell-Lösung wurde nur mit 10 g/l Natriumhydroxid, jedoch ohne Butan-1,4-diol und ohne Natriumcarbonat angesetzt und war klar. Die Quell-Lösung wurde bei 80 °C zum Behandeln von Leiterplatten verwendet. Die Mikroaufrauhung der Harzoberflächen nach der Permanganat-Behandlung war außerordentlich gering, verglichen mit den Ergebnissen nach Vergleichsbeispiel 10. An einigen Stellen der Bohrlochwände war überhaupt keine Mikroaufrauhung erkennbar.

**Patentansprüche**

1. Verfahren zum Behandeln von Polymere enthaltenden Werkstückoberflächen durch Anquellen der Werkstückoberflächen mit einer alterungsbeständigen wäßrigen Lösung, enthaltend mindestens ein geeignetes organisches Quellmittel und Alkalisierungsmittel, dadurch gekennzeichnet, daß die Lösung zusätzlich aus dem Alkalisierungsmittel entstandene basische Salze sowie zusätzlich mindestens einen Lösungsvermittler für die Quellmittel in der Lösung enthält, ausgewählt aus der Gruppe der organischen Verbindungen mit der allgemeinen Formel

$$HO-A(OH)-R,$$

wobei

A eine unverzweigte oder verzweigte Alkylenkette,
R eine verzweigte oder unverzweigte Alkylgruppe oder Wasserstoff ist, und
A und R zusammen mindestens drei Kohlenstoffatome enthalten.

2. Verfahren nach Anspruch 1, gekennzeichnet durch die Verwendung von Alkalicarbonaten als basische Salze.

3. Verfahren nach einem der vorstehenden Ansprüche, dadurch gekennzeichnet, daß die wäßrige Lösung auf eine Temperatur oberhalb 60 °C eingestellt wird.

4. Verfahren zur Metallisierung von Polymere enthaltenden Werkstückoberflächen unter Anwendung der Behandlung gemäß einem der vorstehenden Ansprüche und anschließend

- gegebenenfalls Anrauhen,
- Aktivieren und
- Metallisieren der Oberflächen.

5. Verfahren nach einem der vorstehenden Ansprüche, dadurch gekennzeichnet, daß zum Anrauhen alkalische Permanganatlösung oder Chromsäure enthaltende Lösungen eingesetzt werden.

6. Verfahren nach einem der vorstehenden Ansprüche, dadurch gekennzeichnet, daß als Polymere einzelne oder mehrere der Stoffe aus der Gruppe Epoxidharz, Polycarbonat, Polyphenylenoxid, Polyester, Polyamid, Polyimid, Polyetherimid, Polystyrol, Polyvinylchlorid, Acrylnitril-Butadien-Styrol-Copolymere (ABS) oder deren Mischungen eingesetzt werden.

7. Wäßrige alterungsbeständige Lösung, enthaltend mindestens ein geeignetes organisches Quellmittel, Alkalisierungsmittel und aus dem Alkalisierungsmittel entstandene basische Salze, sowie zusätzlich mindestens einen Lösungsvermittler, ausgewählt aus der Gruppe der organischen Verbindungen mit der allgemeinen Formel

$$HO-A(OH)-R,$$

wobei

A eine verzweigte oder unverzweigte Alkylenkette,
R eine verzweigte oder unverzweigte Alkylgruppe oder Wasserstoff ist und
A und R zusammen mindestens drei Kohlenstoffatome enthalten.

8. Lösung nach Anspruch 7, dadurch gekennzeichnet, daß A zwei bis sechs Kohlenstoffatome enthält.

9. Lösung nach einem der Ansprüche 7 oder 8, dadurch gekennzeichnet, daß R eine Alkylgruppe mit weniger als vier Kohlenstoffatomen o.der Wasserstoff ist.

10. Lösung nach einem der Ansprüche 7 - 9, gekennzeichnet durch eine Verbindung oder eine Mischung von Verbindungen, ausgewählt aus der Gruppe 2,2-Dimethyl-1,3-propandiol, Propan-1,2-diol, Pentan-1,5-diol, Butan-1,4-diol, Butan-1,3-diol und Butan-1,2-diol als Lösungsvermittler.

**11.** Lösung nach einem der Ansprüche 7 - 10, gekennzeichnet durch eine Konzentration der Lösungsvermittler in der Lösung zwischen 10 g/l und 500 g/l.

**12.** Lösung nach einem der Ansprüche 7 - 11, gekennzeichnet durch Alkalicarbonate als basische Salze.

**13.** Lösung nach einem der Ansprüche 7 - 12, gekennzeichnet durch organische Quellmittel mit der allgemeinen Formel

$$R_1O\text{-}(A'O)_p\text{-}R_2,$$

wobei

$R_1$ und $R_2$ unabhängig voneinander gewählt werden und Alkyl- oder Acylgruppen mit nicht mehr als fünf Kohlenstoffatomen, Arylgruppen oder Wasserstoff sind und wobei höchstens eine der beiden Gruppen Wasserstoff ist,
A' eine Kohlenstoffgruppe mit zwei bis fünf Kohlenstoffatomen ist und
$p = 1, 2, 3$ oder 4 ist.

**14.** Lösung nach einem der Ansprüche 7 - 13, gekennzeichnet durch Diethylenglykolmonobutylether oder Diethylenglykolmonoethyletheracetat als organisches Quellmittel.

**15.** Lösung nach einem der Ansprüche 7 - 14, gekennzeichnet durch Alkalihydroxide als Alkalisierungsmittel.

## Claims

**1.** Method of treating workpiece surfaces, containing polymers, by swelling the workpiece surfaces with an age-resistant, aqueous solution, containing at least one suitable organic swelling agent and alkalating agent, characterised in that the solution additionally contains basic salts produced from the alkalating agent, as well as additionally containing at least one solubilizer for the swelling agents in the solution, selected from the group of organic compounds having the general formula

$$HO\text{-}A(OH)\text{-}R,$$

wherein A is an unbranched or branched alkylene chain, R is a branched or unbranched alkyl group or hydrogen, and A and R together contain at least three carbon atoms.

**2.** Method according to claim 1, characterised by the use of alkali carbonates as basic salts.

**3.** Method according to one of the preceding claims, characterised in that the aqueous solution is set to a temperature above 60° C.

**4.** Method of metallizing workpiece surfaces, containing polymers, by using the treatment according to one of the preceding claims and subsequently

- possibly roughening,
- activating and
- metallizing the surfaces.

**5.** Method according to one of the preceding claims, characterised in that alkaline permanganate solution or solutions containing chromic acid are used for the roughening operation.

**6.** Method according to one of the preceding claims, characterised in that individual substances or a plurality of the substances from the group epoxy resin, polycarbonate, polyphenylene oxide, polyester, polyamide, polyimide, polyetherimide, polystyrene, polyvinyl chloride, acrylonitrile-butadiene-styrene copolymers (ABS) or their mixtures are used as polymers.

7. Aqueous, age-resistant solution, containing at least one suitable organic swelling agent, alkalating agent and basic salts produced from the alkalating agent, as well as additionally containing at least one solubilizer, selected from the group of organic compounds having the general formula

$$HO\text{-}A(OH)\text{-}R,$$

wherein A is a branched or unbranched alkylene chain, R is a branched or unbranched alkyl group or hydrogen, and A and R together contain at least three carbon atoms.

8. Solution according to claim 7, characterised in that A contains two to six carbon atoms.

9. Solution according to one of claims 7 or 8, characterised in that R is an alkyl group having less than four carbon atoms or hydrogen.

10. Solution according to one of claims 7 - 9, characterised by a compound or a mixture of compounds, selected from the group 2,2-dimethyl-1,3-propanediol, propane-1,2-diol, pentane-1,5-diol, butane-1,4-diol, butane-1,3-diol and butane-1,2-diol as solubilizers.

11. Solution according to one of claims 7 - 10, characterised by a concentration of the solubilizers in the solution between 10 g/l and 500 g/l.

12. Solution according to one of claims 7 - 11, characterised by alkali carbonates as basic salts.

13. Solution according to one of claims 7 - 12, characterised by organic swelling agents having the general formula

$$R_1O\text{-}(A'O)_p\text{-}R_2,$$

wherein $R_1$ and $R_2$ are selected independently of each other and are alkyl or acyl groups with not more than five carbon atoms, aryl groups or hydrogen, and wherein at most one of the two groups is hydrogen, A' is a carbon group having between two and five carbon atoms, and p = 1, 2, 3 or 4.

14. Solution according to one of claims 7 - 13, characterised by diethyleneglycolmonobutylether or diethyleneglycolmonoethyletheracetate as the organic swelling agent.

15. Solution according to one of claims 7 - 14, characterised by alkali hydroxides as alkalating agents.

**Revendications**

1. Procédé pour traiter des surfaces de pièces contenant des polymères par le gonflement des surfaces de pièces avec une solution aqueuse et résistante au vieillissement, contenant au moins un agent de gonflement organique approprié et un moyen d'alcalisation, caractérisé en ce que la solution contient en outre des sels basiques formés à partir du moyen d'alcalisation et en supplément au moins un solubiliseur pour les moyens de gonflement dans la solution, sélectionné à partir du groupe des composés organiques avec la formule générale suivante

$$HO\text{-}A(OH)\text{-}R,$$

A étant une chaîne d'alkylène linéaire ou ramifiée,
R un groupe alkyle ramifié ou linéaire ou de l'hydrogène, et
A et R contenant ensemble au moins trois atomes de carbone.

2. Procédé selon la revendication 1, caractérisé par l'utilisation de carbonates alcalins comme sels basiques.

3. Procédé selon l'une quelconque des revendications précédentes, caractérisé en ce que la solution aqueuse est réglée sur une température supérieure à 60° C.

4. Procédé pour la métallisation de surfaces de pièces contenant des polymères avec l'application du traitement selon l'une quelconque des revendications précédentes et ensuite

- éventuellement en rendant rugueuse,
- en activant et
- en métallisant les surfaces.

5. Procédé selon l'une des quelconque des revendications précédentes, caractérisé en ce qu'on utilise une solution alcaline de permanganate ou des solutions contenant de l'acide chromique pour rendre les surfaces rugueuses.

6. Procédé selon l'une quelconque des revendications précédentes, caractérisé en ce qu'on utilise comme polymères des substances individuelles ou plusieurs des substances provenant du groupe résine époxy, polycarbonate, oxyde de polyphénylène, polyester, polyamide, polyimide, polyétherimide, polystyrène, chlorure de polyvinyle, des copolymères d'acrylnitrile-styrène-butadiène (ABS) ou leurs mélanges.

7. Solution aqueuse et résistante au vieillissement, contenant au moins un agent de gonflement organique et approprié, un agent d'alcalisation et des sels basiques formés à partir de l'agent d'alcalisation, et en outre au moins un solubiliseur, sélectionné à partir du groupe des composés organiques avec la formule générale suivante

$$HO-A(OH)-R,$$

A étant une chaîne d'alkylène ramifiée ou linéaire,
R étant un groupe alkyle ramifié ou linéaire ou de l'hydrogène et
A et R contenant ensemble trois atomes de carbone.

8. Solution selon la revendication 7, caractérisée en ce que A contient deux à six atomes de carbone.

9. Solution selon au moins l'une des revendications 7 ou 8, caractérisée en ce que R est un groupe alkyle avec moins de quatre atomes de carbone ou de l'hydrogène.

10. Solution selon l'une quelconque des revendications 7 à 9, caractérisée par un composé ou un mélange de composés, sélectionnée à partir du groupe 2,2-diméthyl-1,3-propanediol, propane-1,2-diol, pentane-1,5-diol, butane-1,4-diol, butane-1,3-diol et butane-1,2-diol comme solubiliseur.

11. Solution selon l'une quelconque des revendications 7 à 10, caractérisée par une concentration des solubiliseurs dans la solution entre 10 g/l et 500 g/l.

12. Solution selon l'une quelconque des revendications 7 à 11, caractérisée par des carbonates alcalins comme sels basiques.

13. Solution selon l'une quelconque des revendications 7 à 12, caractérisée par des agents de gonflement organiques avec la formule générale suivante

$$R_1O-(A'O)_p-R_2$$

$R_1$ et $R_2$ étant choisis indépendamment l'un de l'autre et étant des groupes alkyle ou acyle avec pas plus de cinq atomes de carbone, des groupes aryle ou de l'hydrogène et au maximum l'un de deux groupes étant de hydrogène,
A' étant un groupe carboné avec deux à cinq atomes de carbone et
p = 1, 2, 3 ou 4.

14. Solution selon l'une quelconque des revendications 7 à 13, caractérisée par de l'éther de monobutyle de diéthylèneglycol ou du étheracétate de monoéthyle de diéthylèneglycol comme agent de gonflement organique.

15. Solution selon l'une quelconque des revendications 7 à 14, caractérisée par des hydroxydes alcalins comme agent d'alcalisation.